# EUROPÄISCHE PATENTSCHRIFT

(11) **EP 1 597 776 B1**
(45) Veröffentlichungstag und Bekanntmachung des Hinweises auf die Patenterteilung: **01.04.2015**
(21) Anmeldenummer: 04702280.1
(22) Anmeldetag: 15.01.2004
(51) Int. Cl.: H01L 33/48, H01L 33/50, H01L 33/56

(54) **LICHTEMITTERENDES HALBLEITERBAUELEMENT**
SEMICONDUCTOR LIGHT EMITTING DEVICE
DISPOSITIF ELECTROLUMINESCENT SEMI-CONDUCTEUR

(30) Priorität: 28.02.2003 DE 10308866
(43) Veröffentlichungstag der Anmeldung: 23.11.2005
(73) Patentinhaber: OSRAM Opto Semiconductors GmbH, 93055 Regensburg (DE)
(72) Erfinder: HÄRLE, Volker, 93164 Laaber (DE); HAHN, Berthold, 93155 Hemau (DE); LUGAUER, Hans-Jürgen, 93161 Sinzing (DE)
(74) Vertreter: Epping - Hermann - Fischer
(86) Internationale Anmeldenummer: PCT/DE2004/000040
(87) Internationale Veröffentlichungsnummer: WO 2004/077578

(56) Entgegenhaltungen:
- EP-A- 1 081 771
- DE-A1- 10 010 638
- DE-A1- 10 020 464
- DE-A1- 10 026 254
- JP-A- H10 233 532
- JP-A- 2002 359 403
- JP-U- 3 017 656
- US-A1- 2002 096 254
- US-A1- 2003 010 986
- US-A1- 2003 160 258
- PATENT ABSTRACTS OF JAPAN Bd. 004, Nr. 112 (E-021), 12. August 1980 (1980-08-12) & JP 55 070080 A (NEC CORP), 27. Mai 1980 (1980-05-27)
- PATENT ABSTRACTS OF JAPAN Bd. 1999, Nr. 11, 30. September 1999 (1999-09-30) & JP 11 161197 A (MATSUSHITA ELECTRIC KK), 18. Juni 1999 (1999-06-18)
- PATENT ABSTRACTS OF JAPAN Bd. 2003, Nr. 01, 14. Januar 2003 (2003-01-14) & JP 2002 252372 A (NICHIA CHEM IND LTD), 6. September 2002 (2002-09-06)
- PATENT ABSTRACTS OF JAPAN Bd. 004, Nr. 165 (E-034), 15. November 1980 (1980-11-15) & JP 55 113387 A (SANYO ELECTRIC; OTHERS), 1. September 1980 (1980-09-01)
- PATENT ABSTRACTS OF JAPAN Bd. 2000, Nr. 13, 5. Februar 2001 (2001-02-05) & JP 2000 299396 A (NIPPON REKKU KK), 24. Oktober 2000 (2000-10-24)
- PATENT ABSTRACTS OF JAPAN Bd. 1999, Nr. 08, 30. Juni 1999 (1999-06-30) & JP 11 087779 A (ROHM CO LTD), 30. März 1999 (1999-03-30)

## Beschreibung

Die Erfindung betrifft ein lichtemittierendes Halbleiterbauelement mit zumindest einem Leuchtdiodenchip.

Eine mögliche Art eines solchen Bauelements ist beispielsweise in der EP 0 933 823 A2 beschrieben. Bei dieser ist ein Leuchtdiodenchip auf einem Leadframe befestigt sowie von einem Gehäuse umgeben, so dass die Lichtauskoppelflächen des Leuchtdiodenchips an eine gasförmige Atmosphäre angrenzen. Eine solche Bauform bietet insbesondere die Möglichkeit, Gehäusematerialien zu verwenden, die unter Einfluß von UV-Strahlung keine Alterung erfahren und/oder deren thermischer Ausdehnungskoeffizient an den des Leadframes angepaßt ist. Ein Nachteil eines solchen Halbleiter-Bauelements ist, daß elektromagnetische Strahlung des Leuchtdiodenchips direkt gegen Luft bzw. gegen ein Gas ausgekoppelt wird. Aufgrund des in der Regel relativ hohen Brechungsindex von Halbleitermaterialien geht hierbei ein Großteil der Lichtintensität durch interne Reflexion, insbesondere durch frustriertere Reflexion an der Grenzfläche Halbleiter/Gasatmosphäre verloren. Da derartige Gehäuse zum Schutz des Leuchtdiodenchips in der Regel auch eine Abdeckung aufweisen, geht durch Reflexionen an Grenzflächen von dieser ein weiterer Teil der Lichtintensität verloren.

Um eine verbesserte Lichtauskopplung zu erreichen, werden Leuchtdiodenchips in der Regel mit einem lichtdurchlässigen Verguß- oder Verkapselungsmaterial mit möglichst hohem Brechungsindex derart eingekapselt, daß insbesondere alle Licht-auskoppelflächen des Leuchtdiodenchips mit diesem bedeckt sind. Ein Beispiel eines solchen Bauelements ist in Möllmer/Waitl, "Siemens SMT-TOPLED für die Oberflächenmontage", Teil 1: Eigenschaften und Besonderheiten (Siemens Components 29 (1991), Heft 4), beschrieben. Eine solche sogenannte TOPLED weist ein oberflächenmontierbares Gehäuse auf. Das Verguß- oder Verkapselungsmaterial, mit dem der Leuchtdiodechip umhüllt ist, ist in der Regel ein Epoxidharz, das bei einer TOPLED eine im wesentlichen plane Auskoppelfläche aufweist. Durch seinen gegenüber Luft relativ hohen Brechungsindex bewirkt das Epoxidharz eine verbesserte Auskopplung von Licht aus dem Leuchtdiodenchip und somit auch eine insgesamt verbesserte Lichtauskopplung an die Umgebung. Zusätzlich kann die Auskoppelfläche des Verguß- oder Verkapselungsmaterials die Form einer Linse aufweisen, wodurch die Lichtauskoppeleffizienz weiter erhöht wird. Alternativ kann eine separate Linse in Abstrahlrichtung des Bauelements auf das Verguß- oder Verkapselungsmaterial aufgebracht werden.

Ein Nachteil dieser Bauformen ist, daß sie bei Verwendung von Leuchtdiodenchips mit relativ kurzer Emissionswellenlänge, insbesondere bei im UV-Bereich emittierenden Leuchtdiodenchips, eine starke Degradation aufgrund von Alterung des hochbrechenden Verguß- oder Verkapselungsmaterials durch die vom Leuchtdioden-Chip emittierte elektromagnetische Strahlung erfahren. Ein weiterer Nachteil ist, daß derartige Verguß- oder Verkapselungsmaterialien verglichen mit Halbleitermaterialien von Leuchtdiodenchips stark unterschiedliche thermische Ausdehnungskoeffizienten aufweisen, wodurch sich eine Begrenzung der Materialmenge und damit eine Begrenzung der Größe des Bauelementes ergibt. Zudem ist das Einkapseln von Leuchtdiodenchips mit Verguß- oder Verkapselungsmaterial relativ teuer und kann beispielsweise im Fall einer TOPLED nahezu 50 % der gesamten Herstellungskosten ausmachen.

DE 100 26 254 A1 beschreibt ein lichtemittierendes Halbleiterbauelement mit einem auf einem elektrischen Anschlussleiter aufweisenden Chipträger aufgebrachten Leuchtdiodenchip, der einer Dicke von 25 µm aufweist, der eine erste und eine zweite elektrische Anschlussseite sowie eine Halbleiterschichtfolge aufweist, die eine n-leitende Halbleiterschicht, eine p-leitende Halbleiterschicht und einen zwischen diesen beiden Halbleiterschichten angeordneten elektromagnetische Strahlung erzeugenden Bereich aufweist, die auf einem Träger angeordnet ist, wobei die zweite Anschlussseite über eine vom Träger abgewandte Vorderseite des Leuchtdiodenchips kontaktiert ist, die an einer zu dem Träger hin gewandten Hauptfläche eine reflektierende Schicht aufweist, die eine Halbleiterschicht mit einer rauhen Fläche aufweist und die eine Auskoppelfläche aufweist, die durch eine von der reflektierenden Schicht abgewandten Hauptfläche definiert ist. Das Halbleiterbauelement weist weiterhin einen Gehäuserahmen auf, der mit einem Gehäusegrundkörper umformten Leadframe eine Gehäusekavität definiert, in der der Leuchtdiodenchip angeordnet ist.

JP 2002 252 372 beschreibt ein lichtemittierendes Halbleiterbauelement mit einem auf einem elektrischen Anschlussleiter aufweisenden Chipträger aufgebrachten Leuchtdiodenchip, wobei eine Gehäusekavität mittels einer strahlungsdurchlässigen Abdeckplatte gasdicht verschlossen ist und ein Lumineszenzkonversionsmaterial auf eine zum Inneren der Gehäusekavität gewandten Hauptfläche der Abdeckplatte aufgebracht ist.

JP H10 233 532 beschreibt ein lichtemittierendes Halbleiterbauelement mit einem auf einem elektrischen Anschlussleiter aufweisenden Chipträger aufgebrachten Leuchtdiodenchip, wobei die Auskoppelfläche des Leuchtdiodenchips an einen mit einem Gas gefüllten Bereich angrenzt.

Aufgabe der vorliegenden Erfindung ist, eine einfachere und günstiger herzustellende Form eines lichtemittierenden Halbleiterbauelements zu entwickeln, das eine möglichst hohe Lichtauskoppeleffizienz aufweist. Zudem soll das Halbleiterbauelement den Einsatz von im UV-Bereich emittierender Leuchtdiodenchips zulassen und keine Einschränkung bezüglich der Anzahl von Leuchtdiodenchips aufweisen.

Diese Aufgabe wird durch ein Halbleiterbauelement mit den Merkmalen des Patentanspruches 1 gelöst.

Vorteilhafte Ausführungsformen und bevorzugte Weiterbildungen des Halbleiterbauelements sind in den abhängigen Patentansprüchen 2 bis 19 angegeben.

Erfindungsgemäß weist ein lichtemittierendes Halbleiterbauelement der eingangs genannten Art zumindest einen Leuchtdiodenchip auf, der auf einem elektrische Anschlußleiter aufweisenden Chipträger aufgebracht ist. Hierbei ist der Leuchtdiodenchip ein Dünnfilm-Leuchtdiodenchip, der eine erste und eine zweite elektrische Anschlußseite sowie eine epitaktisch hergestellte Halbleiterschichtfolge aufweist. Die Halbleiterschichtfolge enthält eine n-leitende Halbleiterschicht, eine p-leitende Halbleiterschicht und einen zwischen diesen beiden Halbleiterschichten angeordneten elektromagnetische Strahlung erzeugenden Bereich, ist auf einem Träger angeordnet und weist an einer zu dem Träger hingewandten Hauptfläche eine reflektierende Schicht auf, die zumindest einen Teil der in der Halbleiterschichtfolge erzeugten elektromagnetischen Strahlung in diese zurückreflektiert. Zudem weist die Halbleiterschichtfolge mindestens eine Halbleiterschicht mit zumindest einer mikrostrukturierten, rauhen Fläche sowie eine Auskoppelfläche auf, die durch eine von der reflektierenden Schicht abgewandten Hauptfläche definiert ist. Neben einem diesartigen Dünnfilm-Leuchtdiodenchip ist ein weiteres wesentliches Merkmal der Erfindung, daß die Auskoppelfläche des Dünnfilm-Leuchtdiodenchips an einem mit einem Gas gefüllten oder mit einem Vakuum versehenen Bereich angrenzt.

Mit einem nach obigem Prinzip aufgebauten Dünnfilm-Leuchtdiodenchip konnte bei einer Lichtauskopplung aus dem Halbleiter gegen Luft eine Auskoppeleffizienz von über 50 % erreicht werden. Zudem wurde die Beobachtung gemacht, daß sich die Auskoppeleffizienz verringern kann, wenn man den Dünnfilm-Leuchtdipdenchip wie einen herkömmlichen Leuchtdiodenchip (nicht Dünnfilm-Leuchtdiodenchip) in einem TOPLED-Gehäuse mit Epoxidharzverguß versieht. Beim Einbau des Dünnfilm-Leuchtdiodenchips in ein anderes Gehäuse mit Epoxidharzverguß, bei dem dieser eine linsenförmig ausgebildete Auskoppelfläche aufweist, wurde zwar eine Steigerung der Lichtauskoppeleffizienz beobachtet, die jedoch verglichen mit herkömmlichen in ein derartiges Gehäuse eingebauten Arten von Leuchtdiodenchips, sehr gering ist.

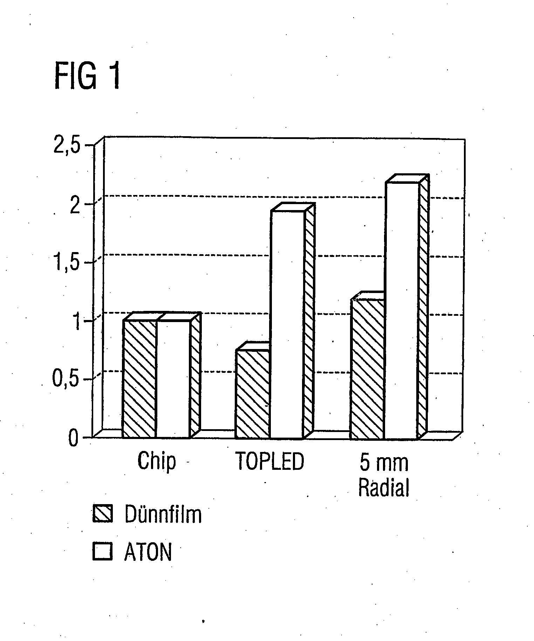

Die Ergebnisse derartiger Messungen sind im Diagramm der Figur 1 graphisch zusammengefaßt. Gezeigt ist jeweils die Auskoppeleffizienz (aufgtragen an der y-Achse) von einem Dünnfilm-Leuchtdiodenchip (dunkle Balken) und einem sogenannten ATON-Leuchtdiodenchip (helle Balken) in drei verschiedenen Gehäusebauformen (aufgetragen entlang der x-Achse). Bei einem ATON-Leuchtdiodenchip ist charakteristisch, dass ein wesentlicher Teil der vom Chip emittierten Strahlung durch das Substrat aus dem Chip ausgekoppelt wird. Beispiele für einen derartigen Chip sind in der WO 01/61764 A1 angegeben. Die Auskoppeleffizienz der vergossenen Chips ist relativ zur Auskoppeleffizienz der jeweiligen Leuchtdiodenchips gegen Luft aufgetragen, die jeweils mit 1 normiert ist.

Die erste Bauform weist keinen Verguß auf, d.h. die Auskopplung aus dem Leuchtdiodenchip geschieht hier direkt gegen Luft, so daß die relative Auskoppeleffizienz definitionsgemäß für beide Arten von Leuchtdiodenchip die Norm bzw. 1 ergibt, was aber nicht bedeutet, dass absolut gesehen der untersuchte Dünnfilm-Chip unter untersuchte ATON-Chip die gleiche Auskoppeleffizienz aufweisen.

Die zweite Bauform ist ein TOPLED-Gehäuse mit einem eine plane Auskoppelfläche aufweisenden Epoxidharzverguß. Während durch den Einbau eines ATON-Leuchtdiodenchips in ein derartiges Gehäuse die Auskoppeleffizienz um fast 100 % erhöht wird, wird sie bei einer Dünnfilm-Leuchtdiode durch den Einbau in das Gehäuse um rund 20 % verringert.

Bei der dritten Bauform schließlich, die ein herkömmliches radiales LED-Gehäuse mit einem Epoxidharzverguß mit linsenförmig ausgebildeter Auskoppelfläche aufweist, erreicht man bei einem ATON-Leuchtdiodenchip eine Verbesserung der Auskoppeleffizienz von über 100 %, während man bei dem verwendeten Dünnfilm-Leuchtdiodenchip zwar auch eine Verbesserung der Auskoppeleffizienz beobachtet, diese aber lediglich etwa 20 % beträgt.

Eine mögliche Interpretation dieser Beobachtungen ist, daß von einem Leuchtdiodenchip ausgesandtes Licht beim Übergang vom Epoxidharz in Luft einen Intensitätsverlust erfährt, während es beim Übergang vom Halbleiter in das Epoxidharz, vergleichen mit dem Übergang vom Halbleiter in.Luft, einen Intensitätsgewinn erfährt. Der Intensitätsverlust ist vor allem auf die Reflexion des Lichtes an der Grenzfläche Epoxidharz/Luft sowie auf Absorption des Lichts im Epoxidharz zurückzuführen, während der Intensitätsgewinn aufgrund des höheren Brechungsindex des Epoxidharzes und die dadurch verringerte Reflexion. Offensichtlich ist der Intensitätsgewinn durch die Auskopplung in den Verguß bei herkömmlichen Leuchtdiodenchips so groß, daß er den Intensitätsverlust bei der Auskopplung aus dem Verguß weit überkompensiert, während der Intensitätsgewinn bei einem Dünnfilm-Leuchtdiodenchip so gering sein kann, daß der Intensitätsverlust je nach Gehäusebauform überwiegt oder nur leicht überkompensiert wird.

Derartige Dünnfilm-Leuchtdiodenchips sind beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird. Weitere Dünnfilm-Leuchtdiodenchips und Verfahren zu deren Herstellung sind in den deutschen Patentanmeldung 10245628.3, 10234977.0 und 10305100.7 sowie in der WO 02/13281 A1 beschrieben, deren Inhalt insofern hiermit ebenfalls jeweils durch Rückbezug aufgenommen wird.

Ein lichtemittierendes Halbleiterbauelement gemäß der Erfindung weist eine Lichtauskoppeleffizienz auf, die mit der von herkömmlichen Bauelementen, bei denen der Leuchtdiodenchip durch ein Verguß- oder Verkapselungsmaterial umhüllt ist, vergleichbar sind. Gleichzeitig kann die Herstellung verglichen mit derartigen Bauelementen einfacher und kostengünstiger geschehen.

Die Halbleiterschichtfolge weist bevorzugt mindestens ein Material aus dem System InₓAl_{y}Ga_{1-x-y}N mit 0 ≤ x ≤ 1, 0 ≤ y ≤ 1 und x + y ≤ 1 auf.

Bei der Erfindung werden Halbleiterschichtfolgen eingesetzt, die elektromagnetische Strahlung mit einer Wellenlänge im UV-Bereich erzeugen. Dadurch, daß die Auskoppelfläche des Dünnfilm-Leuchtdiodenchips frei von hochbrechendem Gehäusematerial wie Verguß- oder Verkapselungsmaterial ist, können alle Materialien des Halbleiterbauelements ohne wesentlichen Nachteil derart gewählt werden, daß sie unter Einfluß von UV-Strahlung nicht oder nur geringfügig altern.

Die Auskoppelfläche des Dünnfilm-Leuchtdiodenchips grenzt an einen mit einem Gas gefüllten und/oder mit einem Vakuum versehenen Bereich an.

Der Träger, auf dem die epitaktisch hergestellte Halbleiterschichtfolge angeordnet ist, ist in einer bevorzugten Ausführungsform des Halbleiterbauelements ein separat gefertigtes und nach dem Aufwachsen der Halbleiterschichtenfolge mit dieser verbundenes Trägersubstrat, insbesondere ein Halbleiter-Trägersubstrat. Ein solches Trägersubstrat wird aufgrund des besonderen Herstellungsverfahrens von Dünnfilm-Leuchtdioden benötigt, bei dem ein Aufwachssubstrat zumindest größtenteils von der Halbleiterschichtfolge entfernt wird, um die Auskoppelfläche des Dünnfilm-Leuchtdiodenchips freizulegen bzw. zu erzeugen.

Alternativ kann auch mit Vorteil auf ein separates Trägersubstrat verzichtet werden, wobei dann der Chipträger des Halbleiterbauelements die Funktion des Trägers für die Halbleiterschichtfolge übernimmt. Dadurch läßt sich die Höhe des Halbleiterbauelements verringern.

In der Ausführungsform des erfindungsgemäßen Halbleiterbauelements weist dieses einen Gehäuserahmen auf, der auf dem Chipträger oder auf einem davon unterschiedlichen, elektrische Anschlußleiter aufweisenden Gehäuseböden angeordnet ist und der mit diesem eine Gehäusekavität definiert, in der der Dünnfilm-Leuchtdiodenchip angeordnet ist. Für den Fall, daß der Gehäuserahmen auf einem Gehäuseboden angeordnet ist, ist der Chipträger auf diesem Gehäuseboden aufgebracht sowie an die Anschlußleiter des Gehäusebodens elektrisch angeschlossen.

Bevorzugt ist die Gehäusekavität durch ein mit einem Gehäusegrundkörper umformtes Leadframe definiert, wobei der Boden des Gehäusegrundkörpers mit dem darin integrierten Teil des Leadframes den Chipträger oder den Gehäuseboden bildet. Hierbei besteht der Gehäusegrundkörper zweckmäßigerweise im wesentlichen aus Kunststoff.

Alternativ ist der Chipträger oder der Gehäuseboden eine Leiterplatte, die eine bevorzugt Kupfer enthaltende Metallplatte aufweist, welche mit der ersten elektrischen Anschlußseite des Dünnfilm-Leuchtdiodenchips sowohl elektrisch als auch thermisch leitend verbunden ist. Die Metallplatte kann sowohl zum elektrischen Anschließen des Dünnfilm-Leuchtdiodenchips als auch zum Abführen von im Dünnfilm-Leuchtdiodenchip erzeugter Wärme verwendet werden.

Innenwände der Gehäusekavität sind vorteilhafterweise zumindest teilweise mit einer Schicht, bevorzugt mit einer metallischen oder oxidischen Schicht, besonders bevorzugt mit einer TiO₂, Ag, Al oder Au aufweisenden Schicht versehen, die für eine im Halbleiterbauelement erzeugte elektromagnetische Strahlung reflektierend ist. Eine derartige reflektierende Schicht kann zum einen der besseren Auskopplung von Licht aus dem Halbleiterbauelement dienen und kann zudem als Schutz von Material der Gehäusekavität vor der elektromagnetischen Strahlung verwendet werden, was insbesondere vorteilhaft ist, wenn der Dünnfilm-Leuchtdiodenchip UV-Strahlung aussendet und das Gehäuse Kunststoff aufweist, der unter Einfluß von UV-Strahlung altert.

Mit besonderem Vorteil ist die reflektierende Schicht elektrisch leitend und zudem mit der zweiten elektrischen Anschlußseite des Dünnfilm-Leuchtdiodenchips elektrisch leitend verbunden. Somit kann die reflektierende Schicht zusätzlich als ein elektrischer Anschlußleiter des Dünnfilm-Leuchtdiodenchips verwendet werden.

Bei einer anderen vorteilhaften Ausgestaltung sind Innenwände der Gehäusekavität zumindest teilweise mit einem Diffusormaterial versehen. Für den Fall, daß die Innenwände der Gehäusekavität mit einer reflektierenden Schicht versehen sind, kann das Diffusormaterial zweckmäßigerweise auf diese aufgebracht sein. Alternativ oder zusätzlich können die Innenwände der Gehäusekavität auch mit einer für eine im Halbleiterbauelement erzeugte elektromagnetische Strahlung diffus reflektierenden Schicht versehen sein, insbesondere dann, wenn keine weitere reflektierende Schicht vorhanden ist.

Mit Vorteil ist die Gehäusekavität gasdicht und/oder wasserdicht verschlossen.

In einer besonders bevorzugten Ausführungsform des Halbleiterbauelements weist dieses eine strahlungsdurchlässige Abdeckplatte auf, die derart angebracht ist, daß sie die Öffnung der Gehäusekavität im wesentlichen abdeckt und/oder schließt. Diese dient z.B. als Schutz des Dünnfilm-Leuchtdiodenchips vor äußeren mechanischen oder chemischen Einflüssen.

Die Abdeckplatte ist mit Vorteil zumindest derart ausgeformt, daß sie eine optische Einrichtung zur Strahlformung einer vom Halbleiterbauelement emittierten elektromagnetischen Strahlung, bevorzugt eine Fokussiervorrichtung aufweist.

Bevorzugt besteht die Abdeckplatte im wesentlichen zumindest aus einem der Materialien Glas, Quarzglas, Keramik oder Glaskeramik.

Mit Vorteil kann die Abdeckplatte mit einem Diffusormaterial versehen sein, das in der Abdeckplatte enthalten und zusätzlich oder alternativ auf der Abdeckplatte aufgebracht ist.

In einer besonders bevorzugten Ausführungsform des Halbleiterbauelements weist mindestens eine Hauptfläche der Abdeckplatte, bevorzugt die zum Inneren der Gehäusekavität gewandte Hauptfläche der Abdeckplatte eine rauhe Struktur auf. Dadurch können Lichtintensitätsverluste aufgrund von Reflexion an Grenzflächen der Abdeckplatte, insbesondere aufgrund von frustrierter Reflexion, verringert werden. Hierzu ist es vorteilhaft, wenn die rauhe Struktur der Hauptfläche der Abdeckplatte unregelmäßig ausgebildet ist.

In einer bevorzugten Ausführungsform weist die rauhe Struktur der Hauptfläche der Abdeckplatte eine Vielzahl von Teilflächen auf, die schräg zu einer Haupterstreckungsebene der Halbleiterschichtfolge stehen und mit dieser eine Vielzahl verschiedener Winkel einschließen. Insbesondere bezüglich dieser Winkel sind die Teilflächen statistisch über die gesamte Hauptfläche verteilt. Wird ein elektromagnetischer 'Strahl an einer derart strukturierten Fläche reflektiert, ist die Wahrscheinlichkeit für eine frustrierte Reflexion gering, da der Strahl bei einem erneuten Auftreffen auf die Fläche mit großer Wahrscheinlichkeit unter einem anderen Einfallswinkel auf eine Teilfläche der strukturierten Fläche trifft als beim vorhergehenden mal, so daß sich die Wahrscheinlichkeit zur Auskopplung eines solchen elektromagnetischen Strahls aus dem Gehäuse erhöht.

Die rauhe Struktur der Hauptfläche der Abdeckplatte weist besonders bevorzugt eine Strukturgröße auf, die in der Größenordnung der Wellenlänge einer von dem Halbleiterbauelement ausgesandten elektromagnetischen Strahlung liegt.

In der Ausführungsform des erfindungsgemäßen Halbleiterbauelements ist der Dünnfilm-Leuchtdiode in Abstrahlrichtung ein Lumineszenz-Konversionsmaterial nachgeordnet, welches zumindest einen Teil einer von der Dünnfilm-Leuchtdiode ausgesandten elektromagnetischen Strahlung wellenlängenkonvertiert, d.h. welches diese Strahlung absorbiert und daraufhin Strahlung einer anderen Wellenlänge emittiert. Eine resultierende, bevorzugt optisch wahrnehmbare Strahlung des Halbleiterbauelements ergibt sich durch eine Mischung der wellenlängenkonvertierten Strahlung mit der von der Dünnfilm-Leuchtdiode ausgesandten Strahlung, so daß sich dadurch insbesondere auch weißes Licht erzeugen läßt. Die von dem Dünnfilm-Leuchtdiodenchip ausgesandte Strahlung kann auch im Wesentlichen vollständig durch das Lumineszenz-Konversionsmaterial wellenlängenkonvertiert werden, falls gewünscht.

Das Lumineszenz-Konversionsmaterial weist bevorzugt mindestens zwei hinsichtlich Konversionseigenschaften und/oder Partikelgröße verschiedene Leuchtstoffe auf.

Vorteilhafterweise ist die Abdeckplatte mit zumindest einem Teil des Lumineszenz-Konversionsmaterials versetzt. Zusätzlich oder alternativ ist zumindest ein Teil des Lumineszenz-Konversionsmaterials mit Vorteil zumindest auf eine Hauptfläche der Abdeckplatte aufgebracht. Bevorzugt ist dies eine zum Inneren der Gehäusekavität gewandte Hauptfläche der Abdeckplatte.

Auf die Hauptfläche der Abdeckplatte und/oder die Auskoppelfläche des Dünnfilm-Leuchtdiodenchips ist das Lumineszenz-Konversionsmaterial in Form einer Konverterschicht aufgebracht, deren Oberfläche eine rauhe Struktur aufweist. Durch eine solche Struktur kann die Strahlungsauskoppeleffizienz des Halbleiterbauelements erhöht werden.

Die rauhe Struktur der Konverterschicht ist hierbei besonders bevorzugt unregelmäßig.

Mit besonderem Vorteil weist die rauhe Struktur der Konverterschicht eine Vielzahl von Teilflächen auf, die schräg zu einer Haupterstreckungsebene der Halbleiterschichtfolge stehen und mit dieser eine Vielzahl verschiedener Winkel einschließen. Insbesondere bezüglich dieser Winkel sind die Teilflächen der rauhen Struktur statistisch über die gesamte Konverterschicht verteilt.

In einer bevorzugten Ausführungsform des Halbleiterbauelements weist die Konverterschicht eine Vielzahl von Kristalliten auf und ist die rauhe Struktur der Konverterschicht im, wesentlichen durch die Form der Kristallite unmittelbar oder mittelbar definiert.

Die rauhe Struktur der Konverterschicht weist eine Strukturgröße auf, die in der Größenordnung der Wellenlänge einer von dem Halbleiterbauelement ausgesandten elektromagnetischen Strahlung liegt.

Bei einer weiteren bevorzugten Ausführungsform des Halbleiterbauelements weist dieses mindestens zwei und bevorzugt drei Arten an Dünnfilm-Leuchtdiodenchips weist. Diese senden sichtbares Licht von jeweils unterschiedlicher Wellenlänge aus, welches gemischt wird und Licht eines bestimmten Farbortes im CIE-Diagramm, insbesondere weißes Licht ergibt. Mindestens eine der Arten an Dünnfilm-Leuchtdiodenchips weist hierbei bevorzugt mindestens ein Material aus dem System Inₓ₋Ga_{y}Al_{1-x-y}P mit 0 ≤ x ≤ 1, 0 ≤ y ≤ 1 und x + y ≤ 1 auf.

Vorteilhafterweise weist der Dünnfilm-Leuchtdiodenchip eine Dicke zwischen 0 und einschließlich 100 µm, bevorzugt zwischen 0 und einschließlich 50 µm, besonders bevorzugt zwischen 0 und einschließlich 10 µm auf.

In feiner besonders vorteilhaften Ausführungsform des Licht emittierenden Halbleiterbauelements weist dieses zwischen zumindest einer elektrischen Anschlußseite des Dünnfilm-Leuchtdiodenchips und einem elektrischen Anschlußleiter des Chipträgers eine elektrische Verbindungsleitung auf, die im wesentlichen aus einer Schicht von elektrisch leitfähigem, strahlungsdurchlässigem Material besteht. Insbesondere die Vorderseite des Dünnfilm-Leuchtdiodenchips, d.h. die zur Abstrahlrichtung des Dünnfilm-Leuchtdiodenchips gewandte Seite ist mittels eines derartigen Materials elektrisch angeschlossen, so daß das Halbleiterbauelement keinen ansonsten in der Regel für diesen Zweck verwendeten Bonddraht aufweist. Dadurch läßt sich die Bauhöhe des Halbleiterbauelements verringern. Zudem wird der Dünnfilm-Leuchtdiodenchip dadurch weniger anfällig für äußere mechanische Einflüsse. Ein weiterer Vorteil ist, daß auf ein Bondpad verzichtet werden kann, wodurch sich eine größere strahlungsemittierende Fläche ergibt.

Das elektrisch leitfähige, strahlungsdurchlässige Material weist bevorzugt zumindest ein transparentes elektrisch leitendes Oxid (TCO), besonders bevorzugt Indiumzinnoxid (ITO) oder Zinkoxid (ZnO) auf.

Eine derartige elektrische Verbindungsleitung aus einer Schicht von elektrisch leitfähigem, strahlungsdurchlässigem Material ist in ihrer Anwendung nicht auf ein Halbleiterbauelement gemäß der Erfindung beschränkt. Vielmehr eignet es sich für lichtemittierende Halbleiterbauelemente mit beliebigen Halbleiter-basierten Lichtquellen sowie für Halbleiterbauelemente, bei denen Auskoppelflächen von Lichtquellen durch Verguß- oder Verkapselungsmaterial bedeckt sind. Zudem eignet sich diese Technologie für sämtliche optoelektronischen Bauelemente, bei denen eine elektrisch leistende Verbindung zwischen einer freien Halbleiterfläche und einem elektrischen Anschlußleiter benötigt wird, insbesondere dann, wenn über die Halbleiterfläche elektromagnetische Strahlung emittiert und/oder empfangen wird. Das gleiche gilt für das im Folgenden erläuterte Verfahren zur Herstellung einer solchen elektrischen Verbindungsleitung.

Das Verfahren zur Herstellung eines lichtemittierenden Halbleiterbauelements beinhaltet das Bereit-, stellen zumindest eines Dünnfilm-Leuchtdiodenchips mit einer ersten und einer zweiten elektrischen Anschlußseite und eines Chipträgers mit zumindest einem ersten und zumindest einem zweiten elektrischen Anschlußleiter. Nachfolgend wird der Dünnfilm-Leuchtdiodenchip auf den Chipträger aufgebracht und wird die erste elektrische Anschlußseite mit dem ersten elektrischen Anschlußleiter des Chipträgers elektrisch verbunden. In einem weiteren Verfahrensschritt werden zumindest alle elektrisch leitenden freien Flächen, die nicht elektrisch mit der zweiten elektrischen Anschlußseite des Dünnfilm-Leuchtdiodenchips verbunden werden sollen, mit elektrisch isolierendem Material beschichtet. Insbesondere freie Flächen des ersten Anschlußleiters sowie von Seitenflanken des Dünnfilm-Leuchtdiodenchips werden mit diesem elektrisch isolierendem Material beschichtet. Desweiteren wird eine elektrische Verbindung zwischen der zweiten elektrischen Anschlußseite des Dünnfilm-Leuchtdiodenchips und dem zweiten Anschlußleiter hergestellt, indem der Chipträger und der Dünnfilm-Leuchtdiodenchip ganzflächig mit einem elektrisch leitfähigem, strahlungsdurchlässigem Material beschichtet werden. Nachfolgend wird der Dünnfilm-Leuchtdiodenchip mit den aufgebrachten Materialien getempert.

Ein derartiges Verfahren eignet sich insbesondere zum elektrischen Kontaktieren von besonders dünnen Leuchtdiodenchips, beispielsweise mit einer Dicke von kleiner als 10 µm. Derartige Leuchtdioden lassen sich nicht mittels einem Bonddraht elektrisch leitend anschließen, da sie bei diesem in der Regel verwendeten Verfahren leicht brechen.

Bei einer bevorzugten Ausführung des Verfahrens ist die erste elektrische Anschlußseite auf der Rückseite des Dünnfilm-Leuchtdiodenchips kontaktierbar und geschieht das Aufbringen des Dünnfilm-Leuchtdiodenchips auf den Chipträger sowie das elektrische Verbinden der ersten elektrischen Anschlußseite mit dem ersten elektrischen Anschlußleiter gleichzeitig mittels Auflöten oder Aufkleben des Dünnfilm-Leuchtdiodenchips mit dessen Rückseite auf den ersten elektrischen Anschlußleiter.

Bevorzugt wird vor dem Verfahrensschritt des Herstellens einer elektrischen Verbindung zwischen der zweiten elektrischen Anschlußseite des Dünnfilm-Leuchtdiodenchips und dem zweiten Anschlußleiter elektrisches Kontaktmaterial auf eine Fläche aufgebracht, über die die zweite elektrische Anschlußseite elektrisch kontaktierbar ist. Dies kann für die Ausbildung eines elektrischen Kontaktes mit ausreichend guter elektrischer Leitfähigkeit notwendig sein.

Bei einer besonders vorteilhaften Ausführung des Verfahrens wird das elektrische Kontaktmaterial als eine dünne Schicht, in Form von schmalen Streifen oder in Form von mehreren, auf kleine Teilbereiche beschränkten Schichten aufgebracht. Dadurch läßt sich erreichen, daß die Einbringung von elektrischen Strom in den Dünnfilm-Leuchtdiodenchip gleichmäßig über eine große, vorzugsweise über die gesamte Hauptfläche von diesem geschieht.

Das Beschichten mit dem elektrisch isolierenden Material geschieht bevorzugt, indem dieses zunächst auf dem Chipträger und dem Dünnfilm-Leuchtdiodenchip aufgebracht und nachfolgend, bevorzugt mittels Lithographie derart strukturiert wird, daß die Fläche über die die zweite elektrische Anschlußseite elektrisch kontaktierbar ist, sowie der zweite elektrische Anschlußleiter zumindest teilweise zum elektrischen Verbinden freigelegt sind.

Alternativ geschieht das Beschichten mit dem elektrisch isolierenden Material in einer bevorzugten Ausführung des Verfahrens mittels Siebdruck.

Mit besonderem Vorteil besteht das elektrisch isolierende Material im wesentlichen aus Lötstoplack.

Zusätzlich oder alternativ weist das elektrisch isolierende Material mit Vorteil SiO₂ auf.

Besonders bevorzugt werden bei dem Verfahren eine Vielzahl lichtemittierender Halbleiterbauelemente im wesentlichen gleichzeitig hergestellt. Dazu wird ein Chipträger verwendet, der eine Mehrzahl von Bauteilabschnitten aufweist, die jeweils zumindest einen ersten und zumindest einen zweiten elektrischen Anschlußleiter enthalten. Nachfolgend werden die Halbleiterbauelemente vereinzelt. Eine im wesentlich gleichzeitige Herstellung einer Vielzahl von Halbleiterbauelementen ist insbesondere bezüglich der Herstellung einer elektrischen Verbindung zwischen der zweiten elektrischen Anschlußseite des Dünnfilm-Leuchtdiodenchips und dem zweiten Anschlußleiter einfach und kostengünstig durchführbar, da dies im wesentlichen aus Beschichten des Chipträgers und des Dünnfilm-Leuchtdiodenchips besteht, was auch bei größeren Flächen ohne signifikanten zusätzlichen Aufwand möglich ist.

In einer vorteilhaften Ausführung des Verfahrens sind die Bauteilabschnitte zeilenartig in mindestens einer Zeile angeordnet.

Bevorzugt sind die einzelnen Zeilen durch Schlitze im Chipträger voneinander separiert.

Weitere Vorteile, bevorzugte Ausführungsformen und Weiterbildungen des Leuchtdiodenchips ergeben sich aus den im folgenden in Verbindung mit den Figuren 2a bis 5 erläuterten Ausführungsbeispielen. Es zeigen:
Figuren 2a und 2b eine schematische Schnittansicht je eines Ausführungsbeispiels des erfindungsgemäßen Halbleiterbauelements,
Figuren 3a bis 3c schematische Schnittansichten eines Ausführungsbeispiels des erfindungsgemäßen Halbleiterbauelements bei verschiedenen Verfahrensstadien,
Figur 4a eine schematische Schnittansicht eines weiteren Ausführungsbeipiels des Halbleiterbauelements,
Figur 4b eine schematische Draufsicht des in Figur 4a gezeigten Ausführungsbeispiels,
Figur 4c ein Polardiagramm zur Veranschaulichung einer Verteilung der Lichtintensität in Abhängigkeit des Abstrahlwinkels des in den Figuren 4a und 4b gezeigten Halbleiterbauelements für eine unterschiedliche Anzahl von Dünnfilm-Leuchtdioden und
Figur 5 eine schematische Draufsicht auf einen Chipträger mit einer Vielzahl von Bauteilabschnitten.

In den Ausführungsbeispielen und Figuren sind gleiche oder gleichwirkende Bestandteile jeweils mit den gleichen Bezugszeichen versehen. Die dargestellten Schichtdicken sind nicht als maßstabsgerecht anzusehen, sie sind vielmehr zum besseren Verständnis übertrieben dick dargestellt. Strukturgrößen sind ebenfalls nicht mit dem richtigen Maßstab oder Größenverhältnis zu anderen Elementen der Figuren dargestellt.

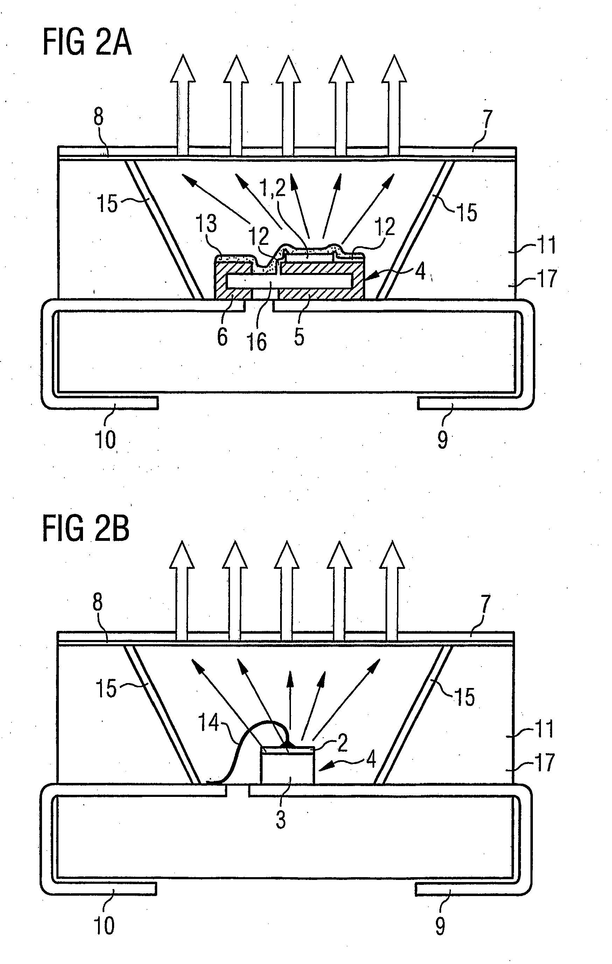

Bei dem in Figur 2a gezeigten Ausführungsbeispiel ist ein auf einem Chipträger 4 aufgebrachter Dünnfilm-Leuchtdiodenchip 1 mittels dem Chipträger 4 auf ein mit einem Gehäusegrundkörper 11 umformtes Leadframe 9,10 montiert. Der Chipträger weist eine erste und eine zweite elektrische Anschlußleitung auf 5,6, die auf einer Trägerplatte 16 aufgebracht und mit den Anschlüssen des Leadframes 9,10 elektrisch leitend verbunden sind, beispielsweise indem sie angelötet oder angeklebt sind. Die Trägerplatte 16 ist derart beschaffen, dass die Anschlußleiter 5,6 voneinander elektrisch isoliert sind. Sie kann beispielsweise aus einer Keramik wie Al₂O₃ bestehen.

Der Teil des Gehäusegrundkörpers 11, der den Gehäuserahmen 17 bildet, weist Innenwände auf, die mit einer reflektierenden Schicht 15 bedeckt sind. Die reflektierende Schicht ist insbesondere für eine im Halbleiterbauelement erzeugte elektromagnetische Strahlung reflektierend und kann beispielsweise aus Aluminium bestehen.

Der Gehäusegrundkörper 11 besteht z.B. aus einem Kunststoff, beispielsweise einem Epoxidharz und ist mit einer Abdeckplatte 7 bedeckt, die zumindest für eine im Halbleiterbauelement erzeugte Strahlung transparent und beipielsweise aus Glas gefertigt ist. Der Gehäusegrundkörper 11 kann mittels der Abdeckplatte 7 gasdicht und/oder wasserdicht verschlossen sein. Auf einer zur Innenseite des Gehäusegrundkörpers 11 gewandten Hauptfläche der Abdeckplatte 7 ist ein Lumineszenz-Konversionsmaterial in Form einer Konverterschicht 8 aufgebracht. Die Oberfläche der Konverterschicht weist eine unregelmäßige, rauhe Struktur mit einer Vielzahl von Teilflächen auf (nicht gezeigt), die schräg zur Haupterstreckungsebene des Dünnfilm-Leuchtdiodenchips 1 stehen und mit dieser eine Vielzahl verschiedenener Winkel einschließen. Die Teilflächen sind vor allem bezüglich dieser Winkel statistisch über die gesamte Oberfläche der Konverterschicht 8 verteilt. Die Konverterschicht enthält beispielsweise Leuchtstoffpartikel auf der Basis von YAG:Ce oder andere geeignete anorganische Leuchtstoffpartikel, wie sie beispielsweise in der WO 98/12757 beschrieben sind.

Die von der Innenseite des Gehäusegrundkörpers 11 abgewandte Hauptfläche der Abdeckplatte 7 kann als optische Linse ausgebildet sein (nicht gezeigt).

Die rauhe Struktur der Konverterschicht ist beispielsweise durch die Form einer Vielzahl unregelmäßig geformter Kristallite, als welche das Lumineszenz-Konversionsmaterial vorliegen kann, definiert. Zusätzlich ist möglich, dass auch die zur Innenseite des Gehäusegrundkörpers 11 gewandte Hauptfläche der Abdeckplatte 7 eine derartige rauhe, unregelmäßige Struktur aufweist. Die Strukturgröße dieser rauhen Strukturen liegt in der Größenordnung der Wellenlänge einer von dem Halbleiterbauelement ausgesandten elektromagnetischen Strahlung, z.B. etwa 300 bis 500 nm. Eine derartige Struktur bewirkt, dass Lichtstrahlen, die an einer Teilfläche der jeweiligen Oberfläche mit einem einem gewissen Winkel auftreffen und reflektiert werden, bei einem Wiederauftreffen auf diese Oberfläche mit großer Wahrscheinlichkeit unter einem anderen Winkel auf eine andere Teilfläche treffen, so daß die Bedingungen für eine Transmission unter Umständen erfüllt sind. Somit können Lichtintensitätsverluste im Halbleiterbaulelement aufgrund von frustrierter Reflexion verringert und effektiv eine bessere Lichtauskopplung erreicht werden.

Das Lumineszenz-Konversionsmaterial der Konverterschicht absorbiert zumindest einen Teil einer von der Dünnfilm-Leuchtdiode 1 ausgesandten elektromagnetischen Strahlung (angedeutet durch die vollen Pfeile), die eine bestimmte Wellenlänge aufweist, und emittiert daraufhin eine Strahlung mit zumindest einer davon unterschiedlichen, in der Regel größeren Wellenlänge. Die verschiedenen Strahlungen durchmischen sich und ergeben Licht eines bestimmten Farbpunktes der CIE Farbtafel, insbesondere weißes Licht (angedeutet durch die nicht ausgefüllten Pfeile). Um eine gute Durchmischung der verschiedenen Strahlungen zu erhalten, kann die Abdeckplatte mit einem Diffusormaterial versehen sein, das in der Abdeckplatte enthalten oder auf dieser aufgebracht sein kann. Zudem kann auch die reflektierende Schicht 15 mit einem Diffusor versehen sein oder aus einem diffus reflektierenden Material bestehen.

Der Dünnfilm-Leuchtdiodenchip 1, der, wie im allgemeinen Teil der Beschreibung beschrieben, beschaffen sein kann, besteht aus einer Halbleiterschichtenfolge 2, die direkt, beispielsweise mittels Löten oder Kleben, auf den ersten elektrischen Anschlußleiter 5 des Chipträgers 4 aufgebracht ist. Dadurch ist zudem eine erste elektrische Anschlußseite des Dünnfilm-Leuchtdiodenchips 1 elektrisch leitend mit dem ersten elektrischen Anschlußleiter 5 verbunden. Die Dicke der Halbleiterschichtfolge kann beispielsweise 8 µm betragen.

Eine solche Halbleiterschichtfolge kann beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Strukur) aufweisen. Solche Strukturen sind dem Fachmann bekannt und werden von daher an dieser Stelle nicht näher erläutert. Ein Beispiel für eine MehrfachQuantentopfstruktur auf der Basis von GaN ist in der WO 01/39282 A2 beschrieben.

Die Halbleiterschichtfolge 2 der Dünnfilm-Leuchtdiode 1 enthält beispielsweise mindestens ein Material aus dem System InₓAl_{y}Ga_{1-x-y}N mit 0 ≤ x ≤ 1, 0 ≤ y ≤ 1 und x+y ≤ 1, und emittiert eine elektromagnetische Strahlung, deren Wellenlänge im UV-Bereich liegt. Die Dünnfilm-Leuchtdiode 1 kann beispielsweise eine InGaN-basierte Leuchtdiode sein. In diesem Fall wird die Strahlung durch die Konverterschicht nahezu vollständig absorbiert und durch zwei oder mehr verschiedene Leuchtstoffe konvertiert. Ein Vorteil der Verwendung einer im UV-Bereich emittierenden Dünnfilm-Leuchtdiode 1 und der nahezu vollständigen Umwandlung einer von dieser ausgehenden Strahlung in sichtbares Licht ist, dass ein von Leuchtstoffen emittiertes Licht in der Regel ein breiteres Spektrum als ein von Leuchtdioden emittiertes Licht aufweist. Somit lässt sich beispielsweise weißes Licht mit einer besseren Farbwiedergabe (Colorrenderingindex) erzeugen.

Die zweite elektrische Anschlußseite des Dünnfilm-Leuchtdiodenchips 1 ist über dessen Vorderseite kontaktierbar. Sie ist mittels einem elektrisch leitfähigen, strahlungsdurchlässigen Material 13 elektrisch leitend mit dem zweiten Anschlußleiter 6 des Chipträgers 4 verbunden. Zur Vermeidung einer elektrisch leitenden Verbindung zwischen dem ersten und dem zweiten Anschlußleiter (5,6) sind freie Flächen des ersten Anschlußleiters 5 sowie die Seitenflanken des Dünnfilm-Leuchtdiodenchips 1 mit elektrisch isolierendem Material 12 bedeckt.

Das elektrisch leitfähige, strahlungsdurchlässige Material 13 kann beispielsweise ein transparentes, elektrisch leitendes Oxid (TCO), wie etwa Indiumzinnoxid (ITO) oder Zinkoxid (ZnO) sein. Das elektrisch isolierende Material 12 besteht beispielsweise aus Lötstoplack oder aus einem Material, das SiO₂ aufweist.

Das in Figur 2b gezeigte Ausführungsbeispiel unterscheidet sich von dem vorhergehend anhand Figur 2a erläuterten Ausführungsbeipiel durch den Träger der Halbleiterschichtfolge 2 des Dünnfilm-Leuchtdiodenchips 1 sowie durch die Art, auf die der Dünnfilm-Leuchtdiodenchip 1 mit den elektrischen Anschlußleitern 9,10 des Leadframes elektrisch verbunden ist.

Der Träger für die Halbleiterschichtfolge 2 ist gemäß dem zweiten Ausführungsbeispiel ein separat hergestelltes Halbleiterträgersubstrat, das mit seiner Rückseite auf den ersten elektrischen Anschlußleiter 9 aufgebracht, z.B. angelötet ist. Dadurch ist auch die erste elektrische Anschlußseite des Dünnfilm-Leuchtdiodenchips 1 elektrisch leitend mit dem ersten elektrischen Anschlußleiter 9 verbunden. Die zweite elektrische Anschlußseite ist über die Vorderseite der Halbleiterschichtfolge 2 mittels einem Bonddraht 14 elektrisch leitend mit dem zweiten elektrischen Anschlußleiter 10 verbunden. Somit ist die Auskoppelfläche, d.h. die zur Abstrahlrichtung gewandte Hauptfläche des Dünnfilm-Leuchtdiodenchips 1, im wesentlichen unbedeckt und grenzt an einen Bereich an, der mit einem Gas, z.B. mit Luft gefüllt und zudem mit einem Vakuum versehen sein kann.

Bei den in den Figuren 2a und 2b gezeigten Ausführungsbeispielen kann Lumineszenz-Konversionsmaterial zusätzlich auch direkt auf die Lichtauskoppelfläche des Dünnfilm-Leuchtdiodenchips 1 bzw. auf das elektrisch leitfähige, strahlungsdurchlässige Material 13 aufgebracht sein oder auch in dem Material der Abdeckplatte enthalten sein. Zudem kann das Lumineszenzkonversionsmaterial verschiedene Leuchtstoffe mit unterschiedlicher Partikelgröße aufweisen.

Neben dem Dünnfilm-Leuchtdiodenchip, der elektromagnetische Strahlung mit einer Wellenlänge im UV-Bereich erzeugt, kann das Bauelement auch meherere aufweisen, die zudem bezüglich des Emissionsspektrums unterschiedlich sein können, so dass sich die Strahlungen unterschiedlicher Wellenlänge zu mischfarbigem Licht mischen. Solche Leuchtdioden emittieren Strahlung des sichtbaren Wellenlängenbereichs und weisen z.B. mindestens ein Material aus dem System InₓGa_{y}Al_{1-x-y}P, mit 0 ≤ x ≤ 1, 0 ≤ y ≤ 1 und x+y ≤ 1 auf.

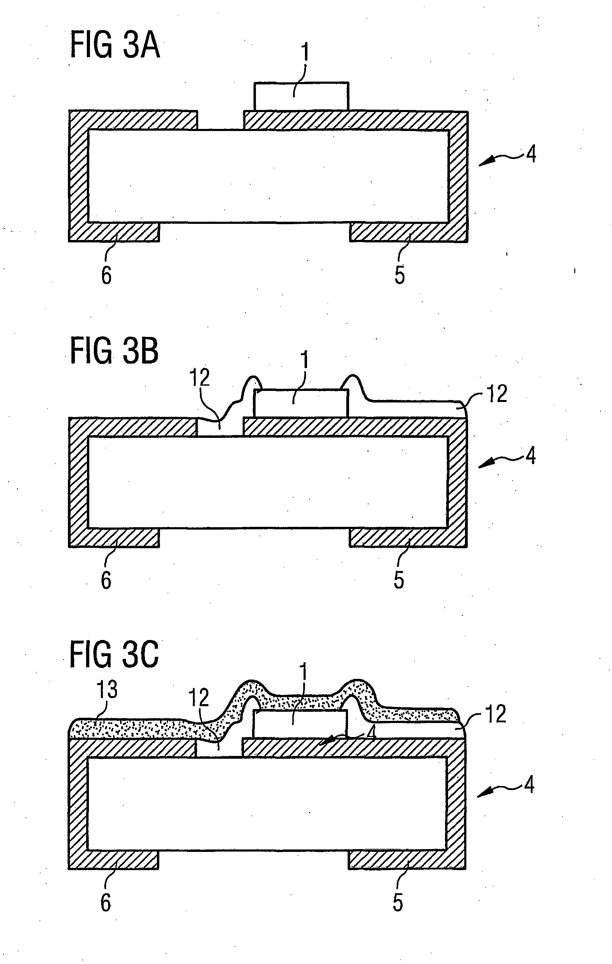

Die Figuren 3a bis 3c zeigen schematische Schnittansichten eines Ausführungsbeispiels des Halbleiterbauelements bei verschiedenen Verfahrensstadien zur Herstellung von diesem. Das Halbleiterbauelement entspricht dem in Figur 2a gezeigten Chipträger 4 mit dem darauf aufgebrachten und mit dessen elektrischen Anschlußleitern 5,6 elektrisch verbundenen Dünnfilm-Leuchtdiodenchip 1. Beim in Figur 2a gezeigten Beispiel ist der Chipträger auf ein mit einem Gehäusegrundkörper 11, umformten Leadframe 9,10 montiert. Die Einsatzmöglichkeit ist jedoch selbstverständlich nicht auf eine solche Bauform beschränkt.

Auf den ersten Anschlußleiter 5 des Chipträger 4 wird der Dünnfilm-Leuchtdiodenchip 1 mit seiner Rückseite aufgebracht und elektrisch leitend mit dem Anschlußleiter 5 verbunden, beispielsweise mittels Löten oder Kleben. Das in Figur 3a gezeigte Verfahrensstadium entspricht einem dadurch erreichten Zustand.

Nachfolgend werden zumindest alle freien Flächen, die nicht mit dem zweiten elektrischen Anschlußleiter 6 elektrisch leitend verbunden werden sollen, mit einem elektrisch isolierenden Material 12 bedeckt. Dies kann entweder mittels einem lithographischen Prozess geschehen oder auch in einem Schritt mittels Siebdruck, was beides beispielsweise mit Lötstoplack möglich ist. Im Beispiel von Figur 3b entspricht das der Bedeckung aller freien Flächen des ersten Anschlußleiters 5 sowie der Seitenflanken des Dünnfilm-Leuchtdiodenchips 1.

Zum Herstellen einer elektrisch leitenden Verbindung zwischen der zweiten elektrischen Anschlußseite des Dünnfilm-Leuchtdiodenchips 1 und dem zweiten elektrischen Anschlußleiter 6 werden die Oberfläche des Chipträgers 4 sowie des Leuchtdiodenchips 1 ganzflächig mit einem elektrisch leitenden, transparenten Material 13 beschichtet, was mit einem dafür geeigneten Beschichtungverfahren geschieht, das dem Fachmann bekannt ist (siehe Figur 3c). Vor dem Beschichten kann auf die Fläche des Leuchtdiodenchips 1, über die dessen zweite elektrische Anschlußseite elektrisch kontaktierbar ist, elektrisches Kontaktmaterial aufgebracht werden (nicht gezeigt). Dies kann beispielsweise Gold sein, das etwa in Form einer dünnen, für elektromagnetische Strahlung durchlässigen Schicht aufgebracht ist.

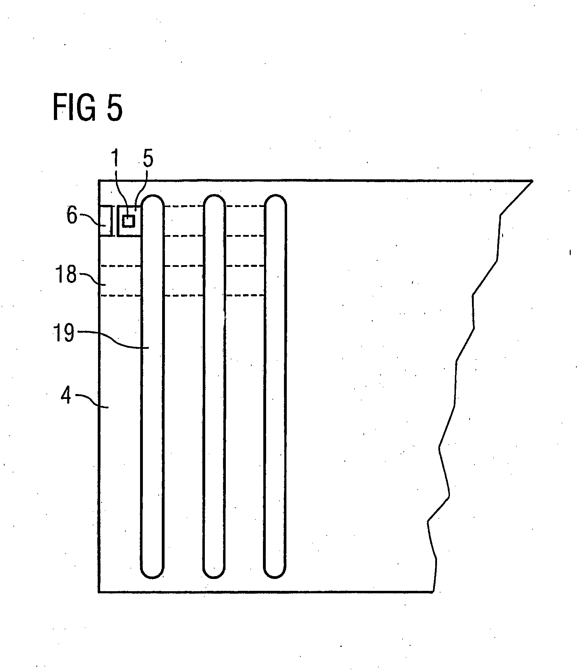

Das Verfahren ist sehr gut geeignet, um mehrere Bauelemente im wesentlichen gleichzeitig herzustellen. Hierzu kann der Chipträger 4 eine Vielzahl von Bauteilabschnitten 18 mit jeweils mindestens einem ersten und einem zweiten elektrischen Anschlußleiter 5,6 aufweisen, wie in Figur 5 schematisch dargestellt. Die Bauteilabschnitte sind hierbei zeilenförmig angeordnet und einzelne Zeilen sind durch Schlitze 19 voneinander separiert. Nachfolgend werden die Bauelemente vereinzelt, können aber auch zu einem beliebigen früheren Zeitpunkt vereinzelt werden oder auch bereits vor dem Verfahren vereinzelt sein.

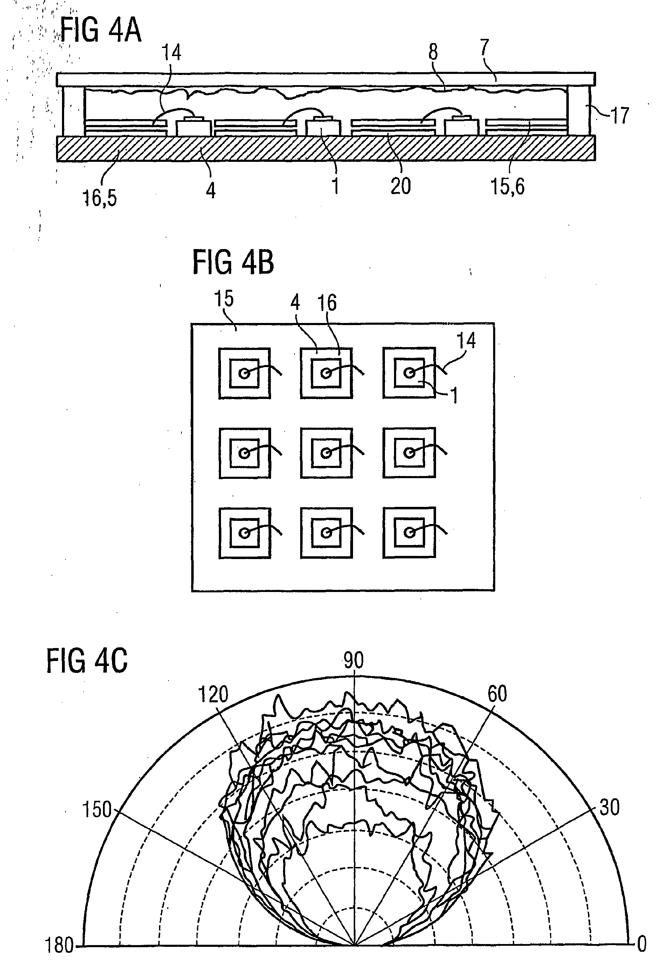

Ein Baüteilabschnitt kann auch mehrere Dünnfilm-Leuchtdioden aufweisen (siehe Figuren 4a und 4b), die ebenfalls durch ein derartiges Verfahren im wesentlichen gleichzeitig elektrisch mit jeweils mindestens einem Anschlußleiter verbunden werden können, als Alternative zu den in Figur gezeigten Bonddrähten. Wenn bei einem Dünnfilm-Leuchtdiodenchip beide elektrische Anschlußseiten jeweils über eine vorderseitige Halbleiterfläch elektrisch kontaktierbar sind, so können beide Anschlußseiten mit besagtem Verfahren mit dem jeweiligen Anschlußleiter elektrisch leitend verbunden werden.

In dem in Figur 4a und 4b gezeigten Ausführungsbeispiel sind eine Vielzahl von Dünnfilm-Leuchtdiodenchips 1 auf einem gemeinsamen Chipträger 4 aufgebracht. Die Trägerplatte 16 des Chipträgers 4 besteht aus elektrisch und thermisch leitfähigem Material, beispielsweise Kupfer, an das die Leuchtdiodenchips 1 mit ihrer Rückseite jeweils elektrisch und thermisch leitend verbunden sind. Somit dient die Trägerplatte als ein erster elektrischer Anschlußleiter 5 und als Wärmesenke, in die vom Leuchtdiodenchip 1 bei dessen Betrieb erzeugte Wärme abgeführt wird. Die zweite elektrische Anschlußseite des Dünnfilm-Leuchtdiodenchips 1 ist jeweils elektrisch leitend mit einer reflektierenden Schicht 15 verbunden, die ebenfalls aus elektrisch leitfähigem Material, z.B. Aluminium besteht und zusätzlich als ein zweiter elektrischer Anschlußleiter 6 dient. Die reflektierende Schicht 15 ist mit einem elektrisch isolierenden Material 20 unterlegt und dadurch elektrisch von der Trägerplatte 16 isoliert.

Der Chipträger 4 weist einen Gehäuserahmen 17 auf, auf den eine mit einer Konverterschicht 8 versehene Abdeckplatte 7 aufgebracht ist.

Die Lichtauskoppelfläche von Dünnfilm-Leuchtdioden ist durch ihre vordere Hauptfläche definiert, wodurch sie in guter Näherung eine Lambertsche Abstrahlcharakteristik aufweisen. Dadurch sind Dünnfilm-Leuchtdioden besonders gut für Bauelemente mit einer Vielzahl von Leuchtdioden geeignet, da man mit ihnen die abgestrahlte Lichtintensität erhöhen kann, ohne die Abstrahlcharakteristik des Bauelements signifikant zu ändern, d.h. sie weisen eine sehr gute Skalierbarkeit auf. Dies ist im Polardiagramm der Figur 4c veranschaulicht, in dem die Abstrahlcharakteristik von Halbleiterbauelementen entsprechend den Figuren 4a und 4b für unterschiedliche Größen, d.h. für eine unterschiedliche Zahl von Dünnfilm-Leuchtdioden aufgezeigt ist (Lichtintensität in Abhängigkeit vom Winkel). Je mehr Leuchtdioden das Bauelement aufweist, desto größer wird die Lichtintensität, die Abstrahlcharakteristik bleibt jedoch im wesentlichen gleich.

Die obige Erläuterung der Erfindung anhand der Ausführungsbeispiele ist selbstverständlich nicht als eine Beschränkung der Erfindung auf diese zu verstehen.

## Patentansprüche

1. Lichtemittierendes Halbleiterbauelement mit zumindest einem auf einem elektrische Anschlußleiter aufweisenden Chipträger (4) aufgebrachten Dünnfilm-Leuchtdiodenchip (1), der eine Dicke zwischen 0 und einschließlich 100 µm, eine erste und eine zweite elektrische Anschlußseite sowie eine epitaktisch hergestellte Halbleiterschichtfolge (2) aufweist, wobei die zweite Anschlußseite über eine vom Chipträger (4) abgewandte Hauptfläche des Dünnfilm-Leuchtdiodenchips(1) kontaktierbar ist und die Halbleiterschichtfolge (2)
- eine n-leitende Halbleiterschicht, eine p-leitende Halbleiterschicht und einen zwischen diesen beiden Halbleiterschichten angeordneten elektromagnetische Strahlung erzeugenden Bereich aufweist,
- auf dem Chipträger (4) angeordnet ist,
- an einer zu dem Chipträger (4) hin gewandten Hauptfläche eine reflektierende Schicht aufweist, die zumindest einen Teil der in der Halbleiterschichtfolge (2) erzeugten elektromagnetischen Strahlung in diese zurückreflektiert,
- mindestens eine Halbleiterschicht mit zumindest einer mikrostrukturierten, rauhen Fläche aufweist und
- eine Auskoppelfläche aufweist, die durch eine von der reflektierenden Schicht abgewandte Hauptfläche definiert ist,
wobei
- die Auskoppelfäche an einen mit einem Gas gefüllten oder mit einem Vakuum versehenen Bereich angrenzt,
- die Halbleiterschichtfolge (2) elektromagnetische Strahlung mit einer Wellenlänge im UV-Bereich erzeugt,
- das Halbleiterbauelement einen Gehäuserahmen (17) aufweist, der entweder auf dem Chipträger (4) oder auf einem davon unterschiedlichen, elektrische Anschlußleiter (9, 10) aufweisenden Gehäuseboden angeordnet ist, wobei auf dem Gehäuseboden der Chipträger (4) aufgebracht und an den Anschlußleitern (9, 10) des Gehäusebodens der Chipträger (4) elektrisch angeschlossen ist, und der Gehäuserahmen (17) mit dem Gehäuseboden eine Gehäusekavität definiert, in der der Dünnfilm-Leuchtdiodenchip (1) angeordnet ist,
- das Halbleiterbauelement eine strahlungsdurchlässige Abdeckplatte (7) aufweist, die derart angebracht ist, dass sie eine Öffnung der Gehäusekavität abdeckt und/oder schließt,
- dem Dünnfilm-Leuchtdiodenchip (1) in Abstrahlrichtung ein Lumineszenz-Konversionsmaterial nachgeordnet ist, welches zumindest einen Teil einer von dem Dünnfilm-Leuchtdiodenchip ausgesandten elektromagnetischen Strahlung wellenlängenkonvertiert,
- das Lumineszenz-Konversionsmaterial in Form einer Konverterschicht (8) auf eine zum Inneren der Gehäusekavität gewandte Hauptfläche der Abdeckplatte (7) aufgebracht ist, und
- die Konverterschicht (8) eine Oberfläche mit einer rauen Struktur aufweist, wobei die raue Struktur der Konverterschicht (8) eine Strukturgröße aufweist, die in der Größenordnung der Wellenlänge der von dem Halbleiterbauelement ausgesandten elektromagnetischen Strahlung liegt.

2. Lichtemittierendes Halbleiterbauelement nach Anspruch 1, **dadurch gekennzeichnet, dass**
die Halbleiterschichtfolge (2) mindestens ein Material aus dem System InₓAl_{y}Ga_{1-x-y}N mit 0 ≤ x ≤ 1, 0 ≤ y ≤ 1 und x+y ≤ 1 enthält.

3. Lichtemittierendes Halbleiterbauelement nach einem der Ansprüche 1 oder 2,
**dadurch gekennzeichnet, dass**
der Träger, auf dem die Halbleiterschichtfolge (2) angeordnet ist, ein Trägersubstrat ist.

4. Lichtemittierendes Halbleiterbauelement nach einem der Ansprüche 1 oder 2,
**dadurch gekennzeichnet, dass**
der Träger, auf dem die Halbleiterschichtfolge (2) angeordnet ist, der Chipträger (4) ist.

5. Lichtemittierendes Halbleiterbauelement nach einem der vorhergehenden Ansprüche,
**dadurch gekennzeichnet, dass**
die Gehäusekavität durch ein mit einem Gehäusegrundkörper (11) umformtes Leadframe definiert ist, wobei der Boden des Gehäusegrundkörpers (11) mit dem darin integrierten Teil des Leadframes den Chipträger (4) oder den Gehäuseboden bildet.

6. Lichtemittierendes Halbleiterbauelement nach Anspruch 5,
**dadurch gekennzeichnet, dass**
der Gehäusegrundkörper (11) aus Kunststoff besteht.

7. Lichtemittierendes Halbleiterbauelement nach einem der vorhergehenden Ansprüche,
**dadurch gekennzeichnet, dass**
der Chipträger (4) oder der Gehäuseboden eine Leiterplatte ist, die eine Metallplatte aufweist, die mit der ersten elektrischen Anschlußseite des Dünnfilm-Leuchtdiodenchips (1) elektrisch und thermisch leitend verbunden ist.

8. Lichtemittierendes Halbleiterbauelement nach einem der vorhergehenden Ansprüche,
**dadurch gekennzeichnet, dass**
Innenwände der Gehäusekavität zumindest teilweise mit einer Schicht (15) versehen sind, die für eine im Halbleiterbauelement erzeugte elektromagnetische Strahlung reflektierend ist.

9. Lichtemittierendes Halbleiterbauelement nach Anspruch 8,
**dadurch gekennzeichnet, dass**
die reflektierende Schicht (15) elektrisch leitend mit der zweiten elektrischen Anschlußseite des Dünnfilm-Leuchtdiodenchips (1) verbunden ist.

10. Lichtemittierendes Halbleiterbauelement nach einem der vorhergehenden Ansprüche,
**dadurch gekennzeichnet, dass**
Innenwände der Gehäusekavität zumindest teilweise mit einem Diffusormaterial oder mit einer für eine im Halbleiterbauelement erzeugte elektromagnetische Strahlung diffus reflektierenden Schicht (15) versehen sind.

11. Lichtemittierendes Halbleiterbauelement nach einem der vorhergehenden Ansprüche,
**dadurch gekennzeichnet, dass**
die Gehäusekavität gasdicht und/oder wasserdicht verschlossen ist.

12. Lichtemittierendes Halbleiterbauelement nach einem der vorhergegenden Ansprüche,
**dadurch gekennzeichnet, dass**
die Abdeckplatte (7) zumindest derart ausgeformt ist, dass sie eine optische Einrichtung zur Strahlformung einer vom Halbleiterbauelement emittierten elektromagnetischen Strahlung aufweist.

13. Lichtemittierendes Halbleiterbauelement nach einem der vorhergehenden Ansprüche,
**dadurch gekennzeichnet, dass**
die Abdeckplatte (7) aus zumindest einem der Materialien Glas, Quarzglas, Keramik oder Glaskeramik besteht.

14. Lichtemittierendes Halbleiterbauelement nach einem der vorhergehenden Ansprüche,
**dadurch gekennzeichnet, dass**
die Abdeckplatte (7) mit einem Diffusormaterial versehen ist, das in der Abdeckplatte (7) enthalten und/oder auf der Abdeckplatte (7) aufgebracht ist.

15. Lichtemittierendes Halbleiterbauelement nach einem der vorhergehenden Ansprüche,
**dadurch gekennzeichnet, dass**
die rauhe Struktur der Konverterschicht (8) unregelmäßig ist.

16. Lichtemittierendes Halbleiterbauelement nach Anspruch 15,
**dadurch gekennzeichnet, dass**
die rauhe Struktur der Konverterschicht (8) eine Vielzahl von Teilflächen aufweist, die schräg zu einer Haupterstreckungsebene der Halbleiterschichtfolge (2) stehen und mit dieser eine Vielzahl verschiedener Winkel einschließen, und die statistisch über die gesamte Konverterschicht (8) verteilt sind.

17. Lichtemittierendes Halbleiterbauelement nach einem der vorhergehenden Ansprüche,
**dadurch gekennzeichnet, dass**
die Konverterschicht (8) eine Vielzahl von Kristalliten aufweist, und dass die rauhe Struktur der Konverterschicht durch die Form der Kristallite definiert ist.

18. Lichtemittierendes Halbleiterbauelement nach einem der vorhergehenden Ansprüche,
**dadurch gekennzeichnet, dass**
das Lumineszenz-Konversionsmaterial mindestens zwei hinsichtlich Konversionseigenschaften und/oder Partikelgröße verschiedene Leuchtstoffe aufweist.

19. Lichtemittierendes Halbleiterbauelement nach einem der vorhergehenden Ansprüche,
**dadurch gekennzeichnet, dass**
der Dünnfilm-Leuchtdiodenchip (1) eine Dicke zwischen 0 und einschließlich 50 µm aufweist.

## Claims

1. Light emitting semiconductor component with at least one thin-film light emitting diode chip (1) which is applied on a chip carrier (4) having electrical connecting conductors and has a thickness of between 0 and 100 µm inclusive, a first and a second electrical connection side and an epitaxially fabricated semiconductor layer sequence (2), the second electrical connection side being contact-connectable via a main area of the thin-film light emitting diode chip (1) facing away from the chip carrier (4) and the semiconductor layer sequence (2)
- having an n-conducting semiconductor layer, a p-conducting semiconductor layer and an electromagnetic radiation generating region arranged between these two semiconductor layers,
- being arranged on the chip carrier (4),
- having a reflective layer at a main area facing toward the chip carrier (4), which reflective layer reflects at least a part of the electromagnetic radiation generated in the semiconductor layer sequence (2) back into the latter,
- having at least one semiconductor layer with at least one micropatterned, rough area and
- having a coupling-out area defined by a main area remote from the reflective layer,
- the coupling-out area adjoining a region which is filled with a gas or provided with a vacuum,
- the semiconductor layer sequence (2) generating electromagnetic radiation with a wavelength in the UV range,
- the semiconductor component having a housing frame (17), which is arranged either on the chip carrier (4) or on a housing bottom which is different therefrom and has electrical connecting conductors (9, 10), the chip carrier (4) being applied on the housing bottom and the chip carrier (4) being electrically connected to the connecting conductors (9, 10) of the housing bottom, and the housing frame (17) defining with the housing bottom a housing cavity in which the thin-film light emitting diode chip (1) is arranged,
- the semiconductor component having a radiation transmissive covering plate (7) fitted in such a way that it covers and/or closes an opening of the housing cavity,
- a luminescence conversion material being arranged downstream of the thin-film light emitting diode chip (1) in the emission direction, which material wavelength-converts at least a part of an electromagnetic radiation emitted by the thin-film light emitting diode chip,
- the luminescence conversion material being applied in the form of a converter layer (8) to a main area of the covering plate (7) that faces the interior of the housing cavity, and
- the converter layer (8) having a surface with a rough structure, the rough structure of the converter layer (8) having a structure size which is of the order of magnitude of the wavelength of the electromagnetic radiation emitted by the semiconductor component.

2. Light emitting semiconductor component according to claim 1,
**characterized in that**
the semiconductor layer sequence (2) contains at least one material from the system InₓAl_{y}Ga_{1-x-y}N where 0 ≤ x ≤ 1, 0 ≤ y ≤ 1 and x + y ≤ 1.

3. Light emitting semiconductor component according to either of claims 1 and 2,
**characterized in that**
the carrier on which the semiconductor layer sequence (2) is arranged is a carrier substrate.

4. Light emitting semiconductor component according to either of claims 1 and 2,
**characterized in that**
the carrier on which the semiconductor layer sequence (2) is arranged is the chip carrier (4).

5. Light emitting semiconductor component according to one of the preceding claims,
**characterized in that**
the housing cavity is defined by a leadframe encased by a housing basic body (11), the bottom of the housing basic body (11) with the part of the leadframe integrated therein forming the chip carrier (4) or the housing bottom.

6. Light emitting semiconductor component according to claim 5,
**characterized in that**
the housing basic body (11) is composed of plastic.

7. Light emitting semiconductor component according to one of the preceding claims,
**characterized in that**
the chip carrier (4) or the housing bottom is a printed circuit board which has a metal plate which is electrically and thermally conductively connected to the first electrical connection side of the thin-film light emitting diode chip (1).

8. Light emitting semiconductor component according to one of the preceding claims,
**characterized in that**
inner walls of the housing cavity are at least partly provided with a layer (15) which is reflective for an electromagnetic radiation generated in the semiconductor component.

9. Light emitting semiconductor component according to claim 8,
**characterized in that**
the reflective layer (15) is electrically conductively connected to the second electrical connection side of the thin-film light emitting diode chip (1).

10. Light emitting semiconductor component according to one of the preceding claims,
**characterized in that**
inner walls of the housing cavity are at least partly provided with a diffusor material or with a layer (15) which is diffusely reflective for an electromagnetic radiation generated in the semiconductor component.

11. Light emitting semiconductor component according to one of the preceding claims,
**characterized in that**
the housing cavity is closed off in gastight and/or watertight fashion.

12. Light emitting semiconductor component according to one of the preceding claims,
**characterized in that**
the covering plate (7) is shaped at least in such a way that it has an optical device for the beam shaping of an electromagnetic radiation emitted by the semiconductor component.

13. Light emitting semiconductor component according to one of the preceding claims,
**characterized in that**
the covering plate (7) comprises at least one of the materials glass, quartz glass, ceramic or glass ceramic.

14. Light emitting semiconductor component according to one of the preceding claims,
**characterized in that**
the covering plate (7) is provided with a diffusor material which is contained in the covering plate (7) and/or is applied on the covering plate (7).

15. Light emitting semiconductor component according to one of the preceding claims,
**characterized in that**
the rough structure of the converter layer (8) is irregular.

16. Light emitting semiconductor component according to claim 15,
**characterized in that**
the rough structure of the converter layer (8) has a multiplicity of partial areas which are oblique with respect to a main plane of extent of the semiconductor layer sequence (2) and form a multiplicity of different angles with the latter, and which are distributed statistically over the entire converter layer (8).

17. Light emitting semiconductor component according to one of the preceding claims,
**characterized in that**
the converter layer (8) has a multiplicity of crystallites, and the rough structure of the converter layer is defined by the form of the crystallites.

18. Light emitting semiconductor component according to one of the preceding claims,
**characterized in that**
the luminescence conversion material has at least two phosphors that differ with regard to conversion properties and/or particle size.

19. Light emitting semiconductor component according to one of the preceding claims,
**characterized in that**
the thin-film light emitting diode chip (1) has a thickness of between 0 and 50 µm inclusive.

## Revendications

1. Élément à semi-conducteur électroluminescent comportant au moins une puce de diode électroluminescente à couche mince (1) déposée sur un support de puce (4) présentant des conducteurs de raccordement électriques, laquelle puce présente une épaisseur comprise entre le 0 et 100 µm inclus, des première et seconde faces de raccordement électriques ainsi qu'une série de couches semi-conductrices (2) formées par croissance épitaxiale, dans lequel la seconde face de raccordement peut être mise en contact par l'intermédiaire d'une surface principale opposée au support de puce (4) de la puce de diode électroluminescente à couche mince (1), et la série de couches semi-conductrices (2)
- présente une couche semi-conductrice de conductivité de type n, une couche semi-conductrice de conductivité de type p et une région génératrice de rayonnement électromagnétique disposée entre lesdites deux couches semi-conductrices,
- est disposée sur le support de puce (4),
- présente une couche réfléchissante sur une surface principale opposée au support de puce (4), laquelle couche rétro-réfléchit au moins une partie du rayonnement électromagnétique généré par la série de couches semi-conductrices (2),
- présente au moins une couche semi-conductrice comportant au moins une surface rugueuse micro-structurée et
- présente une surface de couplage en sortie qui est définie par une surface principale opposée à la couche réfléchissante,
dans lequel
- la surface de couplage en sortie est adjacente à une région remplie de gaz ou mise sous vide,
- la série de couches semi-conductrices (2) génère un rayonnement électromagnétique dont la longueur d'onde se situe dans le domaine UV,
- l'élément à semi-conducteur présente un châssis de boîtier (17) qui est disposé soit sur le support de puce (4) soit sur un fond de boîtier présentant un conducteur de raccordement électrique (9, 10) différent de celui-ci, dans lequel le support de puce (4) est déposé sur le fond de boîtier et le support de puce (4) est électriquement connecté aux conducteurs de raccordement (9, 10), et le châssis de boîtier (17) définit avec le fond de boîtier une cavité de boîtier dans laquelle est disposée la puce de diode électroluminescente à couche mince (1),
- l'élément à semi-conducteur présente une plaque de recouvrement (7) transparente au rayonnement qui est appliquée de manière à recouvrir et/ou refermer une ouverture de la cavité de boîtier,
- un matériau de conversion de luminescence est disposé en aval de la puce de diode électroluminescente à couche mince (1) dans la direction d'émission, lequel matériau soumet à une conversion de longueur d'onde au moins une partie d'un rayonnement électromagnétique émis par la puce de diode électroluminescente à couche mince,
- le matériau de conversion de luminescence est déposé sous la forme d'une couche de conversion (8) sur une surface principale de la plaque de recouvrement (7) qui est opposée à l'intérieur de la cavité de boîtier, et
- la couche de conversion (8) présente une surface de structure rugueuse, dans lequel la structure rugueuse de la couche de conversion (8) présente une taille de structure du même ordre de grandeur que la longueur d'onde du rayonnement électromagnétique émis par l'élément à semi-conducteur.

2. Élément à semi-conducteur électroluminescent selon la revendication 1, **caractérisé en ce que** la série de couches semi-conductrices (2) contient au moins un matériau appartenant au système InₓAl_{y}Ga_{1-x-y}N, avec 0 ≤ x ≤ 1, 0 ≤ y ≤ 1 et x+y ≤ 1.

3. Élément à semi-conducteur électroluminescent selon l'une quelconque des revendications 1 ou 2,
**caractérisé en ce que**
le support sur lequel est disposée la série de couches semi-conductrices (2) est un substrat de support.

4. Élément à semi-conducteur électroluminescent selon l'une quelconque des revendications 1 ou 2,
**caractérisé en ce que**
le support sur lequel est disposée la série de couches semi-conductrices (2) est le support de puce (4).

5. Élément à semi-conducteur électroluminescent selon l'une quelconque des revendications précédentes,
**caractérisé en ce que**
la cavité de boîtier est définie par une grille de connexion réalisée sous la forme d'un corps de base de boîtier (11), dans lequel le fond du corps de base de boîtier (11) forme le support de puce (4) ou le fond de boîtier avec la partie qui y est intégrée de la grille de connexion.

6. Élément à semi-conducteur électroluminescent selon la revendication 5, **caractérisé en ce que**
le corps de base de boîtier (11) est constitué de matière plastique.

7. Élément à semi-conducteur électroluminescent selon l'une quelconque des revendications précédentes,
**caractérisé en ce que**
le support de puce (4) ou le fond de boîtier est une carte de circuit imprimé qui présente une plaque métallique électriquement connectée à la face de raccordement électrique de la puce électroluminescente à couche mince (1) et thermiquement conductrice.

8. Élément à semi-conducteur électroluminescent selon l'une quelconque des revendications précédentes,
**caractérisé en ce que**
les parois internes de la cavité de boîtier sont au moins partiellement munies d'une couche (15) réfléchissante vis-à-vis d'un rayonnement électromagnétique généré dans l'élément à semi-conducteur.

9. Élément à semi-conducteur électroluminescent selon la revendication 8, **caractérisé en ce que** la couche réfléchissante (15) est connectée de manière électriquement conductrice à la seconde face de raccordement électrique de la puce de diode électroluminescente à couche mince (1).

10. Élément à semi-conducteur électroluminescent selon l'une quelconque des revendications précédentes,
**caractérisé en ce que**
les parois internes de la cavité de boîtier sont munies au moins partiellement d'un matériau diffusant ou d'une couche (15) réfléchissant de manière diffuse un rayonnement électromagnétique généré dans l'élément à semi-conducteur.

11. Élément à semi-conducteur électroluminescent selon l'une quelconque des revendications précédentes,
**caractérisé en ce que** la cavité de boîtier est fermée de manière étanche au gaz et/ou à l'eau.

12. Élément à semi-conducteur selon l'une quelconque des revendications précédentes, **caractérisé en ce que**
la plaque de recouvrement (7) est réalisée de manière à ce qu'elle comporte un dispositif optique de formation de faisceau d'un rayonnement électromagnétique émis par l'élément à semi-conducteur.

13. Élément à semi-conducteur électroluminescent selon l'une quelconque des revendications précédentes,
**caractérisé en ce que**
la plaque de recouvrement (7) est constituée d'au moins l'un des matériaux choisis parmi un verre, un verre de quartz, une céramique ou une vitrocéramique.

14. Elément à semi-conducteur électroluminescent selon l'une quelconque des revendications précédentes,
**caractérisé en ce que**
la plaque de recouvrement (7) est munie d'un matériau diffusant qui est contenu dans la plaque de recouvrement (7) et/ou est déposé sur la plaque de recouvrement (7).

15. Élément à semi-conducteur électroluminescent selon l'une quelconque des revendications précédentes,
**caractérisé en ce que**
la structure rugueuse de la couche de conversion (8) est irrégulière.

16. Élément à semi-conducteur électroluminescent selon la revendication 15, **caractérisé en ce que**
la structure rugueuse de la couche de conversion (8) présente une pluralité de surfaces partielles qui sont disposées de manière inclinée par rapport à un plan d'extension principale de la série de couches semi-conductrices (2) et formant avec celle-ci une pluralité d'angles différents, qui sont statistiquement distribués sur l'ensemble de la couche de conversion (8).

17. Élément à semi-conducteur électroluminescent selon l'une quelconque des revendications précédentes,
**caractérisé en ce que**
la couche de conversion (8) présente une pluralité de cristallites, et **en ce que** la structure rugueuse de la couche de conversion est définie par la forme des cristallites.

18. Élément à semi-conducteur électroluminescent selon l'une quelconque des revendications précédentes,
**caractérisé en ce que**
le matériau de conversion de luminescence présente au moins deux matériaux luminescents différents en ce qui concerne les propriétés de conversion et/ou les tailles de particules.

19. Élément à semi-conducteur électroluminescent selon l'une quelconque des revendications précédentes,
**caractérisé en ce que**
la puce de diode électroluminescente à couche mince (1) présente une épaisseur comprise entre le 0 et 50 µm inclus.
